(19) Europäisches Patentamt
European Patent Office
Office européen des brevets

(11) **EP 2 139 046 A1**

(12) **EUROPÄISCHE PATENTANMELDUNG**
veröffentlicht nach Art. 153 Abs. 4 EPÜ

(43) Veröffentlichungstag:
**30.12.2009 Patentblatt 2009/53**

(51) Int Cl.:
***H01L 31/042*** *(2006.01)*

(21) Anmeldenummer: 07834946.1

(22) Anmeldetag: **16.04.2007**

(86) Internationale Anmeldenummer:
**PCT/RU2007/000197**

(87) Internationale Veröffentlichungsnummer:
**WO 2008/127142 (23.10.2008 Gazette 2008/43)**

(84) Benannte Vertragsstaaten:
**AT BE BG CH CY CZ DE DK EE ES FI FR GB GR HU IE IS IT LI LT LU LV MC MT NL PL PT RO SE SI SK TR**

(71) Anmelder: **Zakrytoe Aktsionernoe Obschestvo "Technoexan"**
**Ul. Politekhnicheskaya, 26**
**St.Petersburg, 194021 (RU)**

(72) Erfinder:
• **ALFEROV, Zhores Ivanovich**
**St.Petersburg, 197343 (RU)**
• **ANDREEV, Vyacheslav Mikhailovich**
**St.Petersburg, 195256 (RU)**

• **RUMYANTSEV, Valery Dmitrievich**
**St.Petersburg, 194021 (RU)**
• **TERRA, Arnold Romanovich**
**St.Petersburg, 197348 (RU)**
• **SADCHIKOV, Nikolai Anatolievich**
**St.Petersburg, 196066 (RU)**
• **LOVYGIN, Igor Vladimirovich**
**St.Petersburg, 197343 (RU)**

(74) Vertreter: **Jeck, Anton**
**Jeck - Fleck - Herrmann**
**Patentanwälte**
**Klingengasse 2/1**
**71665 Vaihingen/Enz (DE)**

(54) **FOTOVOLTAISCHES MODUL**

(57) Die Erfindung betrifft ein Photoelektrisches Modul mit einer Frontplatte aus Sikatglas mit Linsenkonzentratoren aus Silikon auf der Rückseite der Frontplatte, Seitenwänden sowie einer Hinterplatte, wobei auf Wärme abführenden Unterlagen auf der oberen Seite der Hinterplatte Solarzellen und damit koaxial angeordnete zusätzliche optische Elemente aufgebaut sind. Die zusätzlichen optischen Elemente sind Bestandteil von Kontrollbaugruppen der Solarzellen. Die genannten Kontrollbaugruppen sind so ausgeführt, dass sie eine individuelle Abdichtung jeder Solarzelle und ihre Abtrennung vom inneren Modulumfang sicherstellen.

EP 2 139 046 A1

**Beschreibung**

Die Erfindung betrifft ein photoelektrisches Modul nach dem Oberbegriff des Anspruchs 1.

Die Erfindung betrifft das Gebiet der Solarenergie und insbesondere die photoelektrischen Energiesammelmodule. Die vorliegende Erfindung ist für die Anwendung in den Solarzellen-Sammelenergieanlagen (Fotovoltaik-Sammelanlagen) bestimmt, welche als autonome Energieversorgungsanlagen und Eigenspeisungssysteme in unterschiedlichen Klimagebieten eingesetzt werden können.

Eines der aussichtsreichsten Verfahren für erneuerbare elektrische Energiegewinnung ist die photoelektrische Umwandlung der konzentrierten Sonnenstrahlung unter Einsatz von intensiven Stufensolarzellen (auch Kaskadensolarzellen genannt) und preisgünstigen optischen Konzentratoren. Die Anwendung von optischen Konzentratoren unter 500-1000-facher Konzentration der Sonnenstrahlung ermöglicht es, die Gesamtfläche der Solarzellen verhältnisgleich abzubauen und den Preis für die erzeugte elektrische Energie wesentlich herabzusenken.

Die Anwendung von Strahlungssammlern ermöglicht es bekanntlich, nicht nur die Energieeffizienz der photoelektrischen Module zu steigern, sondern auch ihre Energie- und wirtschaftlichen Kennziffern zu verbessern. Vorausgesetzt allerdings, dass die Kenndaten der Strahlungssammler auf die Kenndaten der Solarzellen abgestimmt sind. Diese Verbesserung ist durch die Minderung des Verbrauchs von kostspieligen Halbleitermaterialien möglich. Die Konstruktion der photoelektrischen Module mit Sonnenstrahlungssammlern soll ihren wirkungsvollen Langzeitbetrieb unter tatsächlichen Betriebsbedingungen bei einem möglichst niedrigen Preis der erzeugten Leistung sicherstellen. Die Anwendung der photoelektrischen Module erfolgt unter Naturbedingungen der Umwelt. Deswegen muss der Schutz des optischen Systems, der Halbleitereinheit und der Strom ableitenden Kontakte vor solchen Einwirkungen, wie Temperatur- und Druckschwankungen, UV-Sonnenstrahlung, hohe Feuchtigkeit, starker Wind, Staub, Hagel usw., sichergestellt werden. Außerdem wird bei der Absorption der konzentrierten Strahlung ein Teil davon für die Erwärmung der Zelle verbraucht. Deswegen muss die Wärme von der Halbleiterstruktur effizient abgeleitet werden, weil die überflüssige Erwärmung der Zelle ihre Energieumsetzungseigenschaften sowie ihre Standzeit und die Ausgangskennlinie des photoelektrischen Moduls wesentlich beeinträchtigt.

Das bekannte photoelektrische Modul mit Sonnenstrahlungssammlern weist Seitenwände aus Silikatglas auf. An den oberen Kanten der Seitenwände ist eine Frontplatte aus Silikatglas mit Fresnel-Linsen befestigt. An den unteren Kanten ist eine Hinterplatte aus Silikatglas mit Solarzellen und Wärme abführenden Unterlagen befestigt («CONFERENCE RECORD OF THE TWENTY-EIGHT IEEE PHOTOVOLTAIC SPECIALISTS CONFERENCE-2000», Anhorage, Alaska, USA, 2000, p. 1169-1172).

Die Fresnel-Linsen sind aus Silikon ausgebildet. Sie sind quadratisch ausgeführt und dicht aneinander angeordnet. Sie sind fest mit der Glasinnenoberfläche verbunden. Die Glasinnenoberfläche hat dabei eine Schutz- und Trägerfunktion. Jeder Fresnel-Linse ist ihre eigene Solarzelle zugeordnet. Die Solarzellen sind auf der Wärme abführenden Unterlage aus Metall befestigt. Die Wärme abführenden Unterlagen liegen auf der Frontglasoberfläche der Hinterplatte auf und zwar so, dass die Licht aufnehmende Oberfläche der Photozelle im Fokus (Brennfleck) der jeweiligen Fresnel-Linse liegt.

Die Wärme abführende Metallunterlage ist gleichzeitig einer der elektrischen Kontakte der Solarzelle. Als zweiter Kontakt dient der obere Metallbelag des metallplattierten Glashartgewebes, welches auf den Wärme abführenden Unterlagen befestigt ist. An die Wärme abführende Unterlage ist ein Drahtkontakt angelegt. Das andere Ende des Drahtkontakts ist an das Kontaktnetz der Photozelle angeschlossen. Die Schaltung der Solarzellen erfolgt durch Kontakte, die an der Metallunterlage und an dem oberen Metallbelag des Glashartgewebes festgemacht sind.

Anhand seitlicher Glaswände des Moduls ist die Parallelität der Front- und Hinterplatten sowie ihre Anordnung zueinander unter Berücksichtigung der Sicherung einer präzisen Fokussierung sichergestellt.

Während des Betriebs des Moduls konzentrieren die normal zu den Sonnenstrahlen ausgerichteten Fresnel-Linsen das Sonnenlicht und lenken es auf die Licht aufnehmenden Oberflächen der Solarzellen. Die Solarzellen wandeln die Energie der Lichtquanten in elektrische Energie um. Dabei wird eine Potentialdifferenz an ihren Kontakten gebildet. Die durch das Modul erzeugte elektrische Energie wird an einen Außenverbraucher oder an einen Energiespeicher weitergeleitet. Die von den Solarzellen abgeführte Wärme wird über die Wärme abführenden Metallunterlagen verteilt, an das Glas der Hinterplatte übertragen und nachher an die Umgebung abgegeben.

Die Mängel dieses Moduls bestehen darin, dass es eine ungenügend hohe Konzentrationszahl und eine unzureichende Breite der Entorientierungskennlinie aufweist. Das vermindert seine Energieleistung. Außerdem fehlt im bekannten photoelektrischen Modul eine individuelle abgedichtete Isolation jeder einzelnen Solarzelle. Dies erhöht wesentlich die Wahrscheinlichkeit der Entstehung von Degradationsvorgängen in Kennlinien aller Solarzellen des photoelektrischen Moduls infolge einer Unter- bzw. Überschreitung der Kenndaten von Gasmedium, wo alle Solarzellen des Moduls angeordnet sind. Als Ergebnis kann eine gravierende Degradation der Modulkenndaten bis zu einem kompletten Ausfall des Moduls erfolgen.

Es ist ein photoelektrisches Modul bekannt, welches eine Frontplatte aus Silikatglas mit Linsen-Konzentratoren aus Silikon, Seitenwände sowie eine Hinterplatte aufweist. Die Linsen-Konzentratoren sind an der Rückseite der Frontplatte angeordnet. Die Solarzellen und koaxial damit angeordnete zusätzliche optische Elemente sind auf der Oberseite der Hinterplatte, und zwar auf den Wärme abführenden Unterlagen aufgebaut. (RU, Kleinpatent Nr. 44002, Kl. 01L31/00, 2004).

Während des Betriebs des Moduls fokussieren die normal zu den Sonnenstrahlen ausgerichteten Linsenkonzentratoren das Sonnenlicht, indem sie es auf die Licht aufnehmenden Oberflächen der Solarzellen lenken. Die Photozellen wandeln die Lichtquantenenergie in elektrische Energie um, indem sie eine Potentialdifferenz an ihren Kontakten bilden. Die vom Modul erzeugte elektrische Energie wird an einen externen Verbraucher oder einen Energiespeicher weitergeleitet. Die von den Solarzellen abgeführte Wärme wird über die Wärme abführenden Metallunterlagen verteilt, an das Glas der Hinterplatte übertragen und danach in die Umgebung abgeleitet.

Dieses photoelektrische Modul überschreitet seinen Kennwerten nach alle anderen bekannten photoelektrischen Module mit Konzentratoren, einschließlich des oben betrachteten Vergleichserzeugnisses.

Jedoch ist im bekannten photoelektrischen Modul keine individuelle abgedichtete Isolation jeder Solarzelle vorhanden. Dies erhöht wesentlich die Wahrscheinlichkeit der Entstehung von Degradationsvorgängen in den Kennlinien aller Solarzellen des photoelektrischen Moduls, welche durch die Unter- bzw. Überschreitung der Kenndaten von Gasmedium verursacht werden, denn das Gasmedium umfasst alle Solarzellen des Moduls. Dies kann zu einer beachtlichen Degradation der Kennziffern des ganzen Moduls und sogar zu seinem Versagen führen.

Es ist Aufgabe der Erfindung, ein photoelektrisches Modul der eingangs erwähnten Art zu schaffen, bei dem die Zuverlässigkeit gesteigert, die Lebensdauer verlängert sowie die Energieleistung des photoelektrischen Moduls erhöht ist.

Die gestellte Aufgabe wird durch die Merkmale des Anspruchs 1 gelöst.

Dies ist dadurch erreicht, dass eventuelle Degradationsvorgänge in den Kennlinien der Solarzellen des photoelektrischen Moduls vermieden sind, wobei solche Degradationsvorgänge durch Unter- bzw. Überschreitung der Kenndaten von dem die Solarzellen des Moduls umgebenden Gasmedium bedingt sind.

Das photoelektrische Modul weist eine Frontplatte aus Silikatglas, Seitenwände und eine Hinterplatte auf. Auf der Rückseite der Frontplatte sind Linsen-Konzentratoren aus Silikon angeordnet. Auf Wärme abführenden Unterlagen auf der oberen Seite der Hinterplatte sind Solarzellen und die damit koaxial angeordneten zusätzlichen optischen Elemente aufgebaut. Gemäß der Erfindung sind die zusätzlichen optischen Elemente Bestandteil der Kontrollbaugruppen der Solarzellen. Dabei sind die genannten Baugruppen so ausgeführt, dass eine individuelle Abdichtung jeder Solarzelle und ihre Abtrennung von dem inneren Modulumfang sichergestellt ist.

Die Linsenkonzentratoren können als Fresnel-Linsen ausgebildet sein.

Die Linsenkonzentratoren können als plankonvexe Linsen ausgeführt sein.

Zusätzliche optische Elemente können als plankonvexe Linsen ausgebildet sein.

Zusätzliche optische Elemente können als Metallfokone (abbildende Konen) mit Schutzabdeckung aus Glas ausgebildet sein.

Zusätzliche optische Elemente können als Fokone mit innerer Totalreflexion ausgeführt sein.

Zusätzliche optische Elemente können als Fokone mit innerer Totalreflexion ausgebildet und aus Kunststoff gefertigt sein.

Fokone mit der inneren Totalreflexion aus Kunststoff können von oben optisch mit einer Schutzabdeckung aus Glas verbunden sein. Die Außenfläche der Schutzabdeckung aus Glas kann mit einem Reflexionsschutzüberzug beschichtet sein.

Die Verbindungsstellen zwischen der Frontplatte, den Seitenwänden und der Hinterplatte sind luftdicht ausgeführt.

Die Seitenwände und/oder die Hinterplatte können eine oder mehrere flexible Einsatzstücke aufweisen.

Die flexiblen Einsatzstücke sind als ein Balg ausgebildet.

Die flexiblen Einsatzstücke sind aus einem kautschukähnlichen Material gefertigt.

Der Innenumfang des photoelektrischen Moduls kann luftdicht mit einer Einrichtung verbunden sein, welche einen Druckausgleich innerhalb und außerhalb des Moduls sicherstellt.

Die Frontfläche der Frontplatte kann mit einem Reflexionsschutzüberzug beschichtet sein.

Die Oberflächen der sekundären optischen Elemente, welche als plankonvexe Linsen ausgebildet sind, können mit Reflexionsschutzüberzügen beschichtet sein.

Die Hinterplatte kann aus Metall gefertigt sein, welches mit einer Wärme leitenden Elektroisolierschicht versehen ist.

Die Hinterplatte kann aus verzinktem Stahl mit einer Kunststoffbeschichtung gefertigt sein.

Die Hinterplatte ist aus Emailstahl gefertigt.

Die Hinterplatte ist aus Glas gefertigt.

Die Seitenwände sind aus Aluminium oder Aluminiumlegierung gefertigt.

Die Seitenwände sind aus verzinktem Stahl gefertigt.

Die Seitenwände sind aus verzinktem Stahl mit einer Kunststoffbeschichtung gefertigt.

Die Seitenwände sind aus Kunststoff gefertigt.

Die zusätzlichen optischen Elemente in Form von plankonvexen Linsen sind aus Silikatglas gefertigt.

Die Seitenwände sind unter einem Winkel von $0 \leq a < arctg \frac{R-W}{2H}$ zur Normalen zur Ebene der Frontplatte angeordnet, dabei ist

*R* - der Abstand zwischen den optischen Achsen der benachbarten Fresnel-Linsen,

*W* - die Breite der Wärme abführenden Unterlage,

*H* - der Abstand zwischen der Front- und Hinterplatte.

Jede Solarzelle hat ihren eigenen kleinen abgedichteten Umfang mit einer während der Fertigung kontrollierbaren Zusammensetzung des Schutzgases. Die Nichteinhaltung der Zusammensetzung des genannten Schutzgases ist wenig wahrscheinlich. Sollte trotzdem der erwähnte Fehler in der Zusammensetzung des Schutzgases vorliegen, führt er nur zur einer Verschlechterung der Kenndaten nur dieser betroffenen Solarzelle. Da das Modul aus Dutzenden oder Hunderten von Solarzellen besteht, kann ein solcher Fehler praktisch keine Auswirkungen auf die Ausgangskennlinie des gesamten Moduls haben.

Die Erfindung wird anhand von in den Zeichnungen dargestellten Ausführungsbeispielen näher erläutert. Es zeigen:

Fig. 1    eine schematische Darstellung eines photoelektrischen Moduls im Querschnitt,

Fig. 2    ein photoelektrisches Modul mit zusätzlichen optischen Elementen, die in Form von plankonvexen Linsen ausgebildet sind,

Fig. 3    ein photoelektrisches Modul mit zusätzlichen optischen Elementen, die als Metallfokone (abbildende Konen) ausgebildet sind,

Fig. 4    ein photoelektrisches Modul mit zusätzlichen optischen Elementen, die in Form eines Fokons mit innerer Totalreflexion ausgebildet sind und

Fig. 5    ein photoelektrisches Modul mit zusätzlichen optischen Elementen, die in Form eines Fokons mit innerer Totalreflexion ausgebildet sind. Der Fokon ist auf der photoaktiven Oberfläche einer Solarzelle angeordnet.

Das photoelektrische Modul enthält:

- Eine Frontplatte 1 aus Silikatglas mit Linsen-Konzentratoren 2 aus Silikon, die auf der Innenseite der Frontplatte 1 angeordnet sind,
- Seitenwände 3 sowie
- eine Hinterplatte 4. Auf der oberen Seite der Hinterplatte 4 sind auf Wärme abführenden Unterlagen 5 Solarzellen 6 und die mit ihnen koaxial angeordneten zusätzlichen optischen Elemente 7 aufgebaut. Die zusätzlichen optischen Elemente 7 sind auf den Wärme abführenden Unterlagen 5 rings um die Solarzellen 6 angeordnet. Sie gehören zu Kontrollbaugruppen 8, die zum Schutz der Solarzellen angeordnet sind.

Die Konstruktion der Kontrollbaugruppe 8 der Solarzellen stellt eine Abdichtung jeder der Solarzellen 6 vom Innenumfang des Moduls während der Vorstufe des verfahrenstechnischen Fertigungsablaufs der photoelektrischen Module sicher. Dies ermöglicht es, die potentiell unzuverlässigen Solarzellen im Voraus auszusortieren. Das stellt auch eine erhöhte Widerstandsfähigkeit der photoelektrischen Module gegen Einwirkung von der Gesamtheit der ungünstigen Umweltfaktoren sowohl bei der Fertigung der Module als auch während ihres Betriebs sicher.

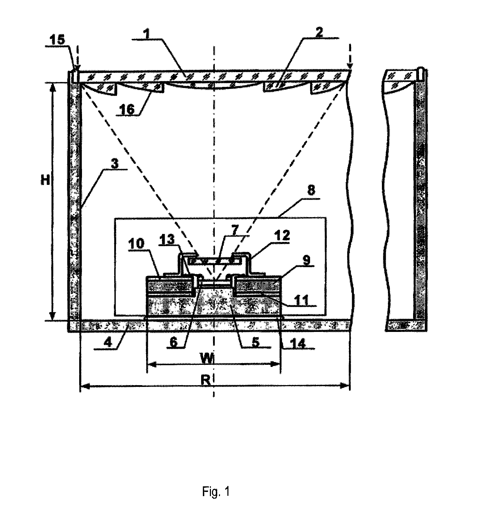

Die Kontrollbaugruppe 8 der Solarzellen kann in Form von gasdicht auf den Wärme abführenden Unterlagen 5 aufgebauten Schienen 9 ausgebildet sein. Die Schienen 9 sind aus Nichtleiterwerkstoff mit Strom leitenden metallisierten Schichten 10 und 11 an beiden Seiten gefertigt. Auf der oberen metallisierten Schicht 10 ist luftdicht ein Metallflansch 12 mit dem zu der Solarzelle 6 koaxial angeordneten zusätzlichen optischen Element 7 aufgebaut. Das zusätzliche optische Element 7 ist luftdicht mit dem Flansch 12 verbunden. Der obere Kontakt der Solarzelle 6 ist elektrisch mittels eines Leiters 13 mit der oberen Strom leitenden Schicht 10 der Schiene 9 gekoppelt (Fig. 1).

Die Wärme abführende Unterlage 5 ist auf die Hinterplatte 4 mittels einer dünnen Compoundschicht 14 gesetzt. Die Solarzellen 6 können an die Wärme abführende Unterlage 5 zum Beispiel mit Weichlot angelötet sein. Die Frontplatte 1 ist luftdicht mittels eines Compounds 15 mit den Seitenwänden 3 zusammengefügt.

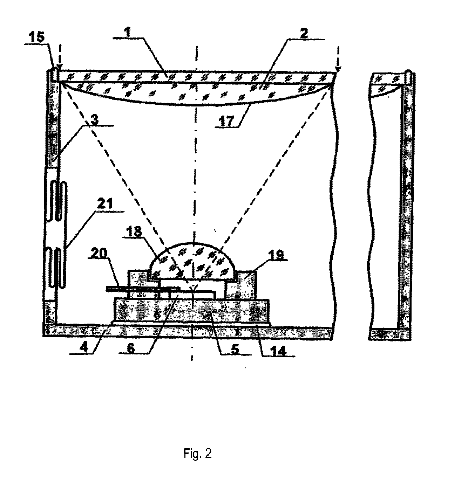

Die Linsenkonzentratoren 2 sind als Fresnel-Linsen 16 oder in Form von plankonvexen Linsen 17 ausgeführt (Fig. 2).

Die Fresnel-Linsen 16 sind aus Silikon gefertigt und weisen quadratische Form auf. Sie sind dicht aneinander angeordnet und mit der Rückfläche der Frontplatte 1 fest verbunden. Jeder Fresnel-Linse 16 ist eine eigene Solarzelle 6 zugeordnet. Die Wärme abführenden Unterlagen 5 befinden sich auf der Frontseite der Hinterplatte 4 und zwar so, dass die Licht aufnehmende Oberfläche der Solarzelle 6 in der optischen Linie der entsprechenden Fresnel-Linse 16 liegt.

Die plankonvexen Linsen 17 sind aus Silikon hergestellt und weisen quadratische Form auf. Sie sind dicht aneinander angeordnet und mit der Rückfläche der Frontplatte 1 fest verbunden. Jeder Linse 17 entspricht eine eigene Solarzelle 6. Die Wärme abführenden Unterlagen 5 befinden sich auf der Frontseite der Hinterplatte 4 und zwar so, dass die Licht aufnehmende Oberfläche der Solarzelle 6 in der optischen Linie der entsprechenden Fresnel-Linse 17 liegt.

In Fig. 2 ist ein photoelektrisches Modul mit zusätzlichen optischen Elementen 7 dargestellt, die in Form von plankonvexen Linsen 18 ausgebildet sind. Der Flansch 19 ist luftdicht auf der Wärme abführenden Unterlage 5 zum Beispiel mit Weichlot befestigt oder verklebt. Somit ist die koaxiale Anordnung der plankonvexen Linse 18 mit der oberen photoaktiven Fläche der Solarzelle 6 sichergestellt. Diese Linse 18 ist auf dem Flansch luftdicht fest verklebt. Der Flansch 19 hat einen abgedichteten elektrischen Eingang 20, welcher an den oberen Kontakt der Solarzelle 6 angeschlossen ist. Die Seitenwand 3 weist ein Einsatzstück in Form von einem Balg 21 auf.

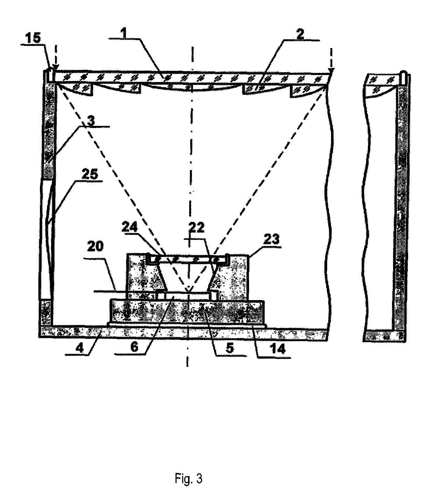

Fig. 3 zeigt ein photoelektrisches Modul mit zusätzlichen optischen Elementen 7, die als Metallfokone (abbildende Konen) 22 ausgebildet sind. Ein Metallflansch 23 ist mit einem Innenloch in Form eines optischen Fokons 22 versehen. Der Fokon 22 ist luftdicht auf der Wärme abführenden Unterlage 5 zum Beispiel mit Weichlot befestigt oder verklebt. Somit ist eine koaxiale Anordnung des Fokons 22 mit der oberen photoaktiven Fläche der Solarzelle 6 sichergestellt. Eine Schutzabdeckung 24 aus Glas ist luftdicht auf dem Flansch 23 mit Kleber befestigt. Der Flansch 23 hat einen abgedichteten elektrischen Ausgang 20, welcher an den oberen Kontakt der Solarzelle 6 angeschlossen ist. Die Seitenwand 3 hat ein flexibles Einsatzstück 25.

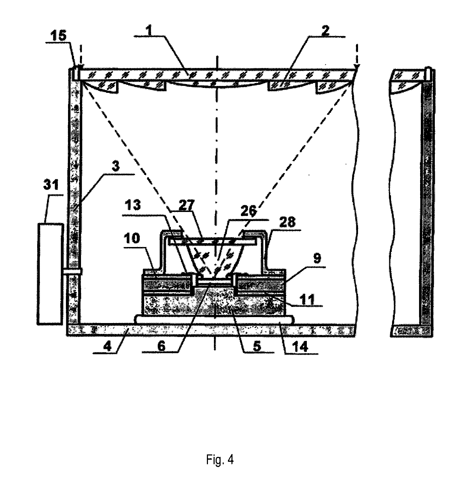

Fig. 4 zeigt ein photoelektrisches Modul mit zusätzlichen optischen Elementen 7 in Form eines Fokons 26 mit innerer Totalreflexion. Der Fokon 26 wird auf der inneren Oberfläche einer Schutzabdeckung 27 ausgebildet und weist einen optischen Kontakt mit der photoaktiven Oberfläche der Solarzelle 6 auf.

Die Schutzabdeckung 27 aus Glas ist luftdicht auf dem Flansch 28 mittels eines Klebers befestigt. Der Fokon 26 kann aus Kunststoff ausgebildet sein.

Der Innenumfang des photoelektrischen Moduls ist luftdicht mit einer Einrichtung 31 verbunden, welche einen Druckausgleich innerhalb und außerhalb des Moduls sicherstellt.

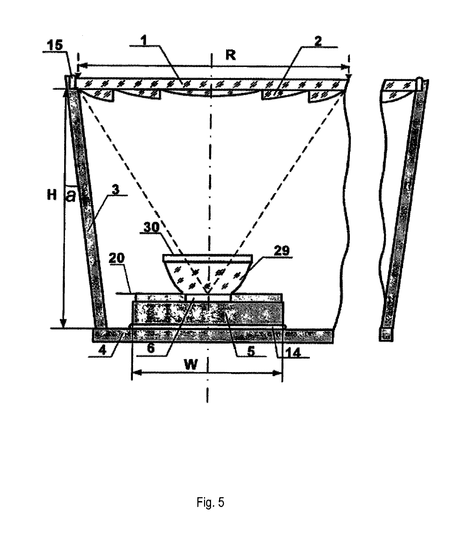

In Fig. 5 ist ein photoelektrisches Modul mit zusätzlichen optischen Elementen 7 dargestellt, welche in Form eines Fokons 29 mit innerer Totalreflexion ausgebildet sind. Der Fokon 29 ist auf der photoaktiven Oberfläche der Solarzelle 6 angeordnet.

Der für die Herstellung eines solchen Fokons benutzte optische Compound stellt gleichzeitig einen Schutz der Solarzelle 6 vor Umwelteinflüssen dar. Der Fokon 29 ist oben mit einer Schutzabdeckung 30 aus Glas versehen. Die Außenfläche der Schutzabdeckung 30 kann mit einem Reflexionsschutzüberzug beschichtet sein, um die optischen Verluste zu mindern. Der Fokon 29 kann aus Kunststoff gefertigt sein.

Die Fig. 4 und 5 enthalten Ausführungsformen dieser Erfindung mit Fokonen, die einen Effekt einer inneren Totalreflexion an der Schnittstelle zwischen zwei optischen Medien mit unterschiedlichen Lichtbrechungszahlen benutzen.

Die Seitenwände 3 und/oder die Hinterplatte 4 können eine oder mehrere flexible Einsatzstücke 25 aufweisen, um die mechanischen Beanspruchungen der Modulkonstruktion während einer Druckänderung innerhalb und außerhalb des Moduls auszugleichen.

Die flexiblen Einsatzstücke 25 können in Form von einem Balg 21 ausgebildet sein.

Die flexiblen Einsatzstücke 25 können aus einem kautschukähnlichen Material gefertigt sein.

Der Innenumfang des photoelektrischen Moduls kann luftdicht mit einer Einrichtung 31 verbunden sein, welche den Druckausgleich innerhalb und außerhalb des Moduls sicherstellt.

Die Außenfläche der Frontplatte 1 kann mit einem Reflexionsschutzüberzug beschichtet sein, um die optischen Verluste abzubauen.

Beide Flächen der zusätzlichen optischen Elemente in Form von plankonvexen Linsen 18 können mit Reflexionsschutzüberzügen beschichtet sein, um die optischen Verluste abzubauen.

Die Hinterplatte 4 ist aus Metall mit einer Wärme leitenden Elektroisolierschicht gefertigt, um die elektrische Isolation der Solarzellen von der Hinterplatte aus Metall des Moduls sicherzustellen.

Die Hinterplatte 4 ist aus verzinktem Stahl mit einer Kunststoffbeschichtung ausgeführt, um die Widerstandsfähigkeit des Moduls gegenüber ungünstigen Umweltfaktoren sicherzustellen.

Die Hinterplatte 4 ist aus Emailstahl gefertigt, um die Widerstandsfähigkeit des Moduls gegenüber ungünstigen Umweltfaktoren zu erhöhen und die elektrische Isolation der Solarzellen von der Hinterplatte aus Metall des Moduls sicherzustellen.

Die Hinterplatte 4 ist aus Glas gefertigt, um die Widerstandfähigkeit des Moduls gegenüber ungünstigen Umweltfaktoren zu erhöhen und die elektrische Isolation der Solarzellen von der Hinterplatte aus Metall des Moduls sicherzustellen.

Die Seitenwände 3 sind aus Aluminium oder einer Aluminiumlegierung gefertigt, um das Gewicht des Moduls niedrig zu halten.

Die Seitenwände 3 sind aus verzinktem Stahl ausgeführt, um die Widerstandsfähigkeit des Moduls gegenüber ungünstigen Umweltfaktoren zu erhöhen.

Die Seitenwände 3 sind aus verzinktem Stahl mit einer Kunststoffbeschichtung ausgeführt, um die Widerstandsfähigkeit des Moduls gegenüber ungünstigen Umweltfaktoren zusätzlich zu erhöhen.

Die Seitenwände 3 sind aus Kunststoff gefertigt, um das Gewicht des Moduls abzubauen und die Widerstandsfähigkeit des Moduls gegenüber ungünstigen Umweltfaktoren zu erhöhen.

Die zusätzlichen optischen Elemente 7 in Form von plankonvexen Linsen 18 sind aus Silikatglas ausgeführt, um die optischen Verluste zu mindern.

Die Seitenwände 3 sind unter einem Winkel von

$$0 \leq a < arctg \, \frac{R-W}{2H}$$ zur Normalen zur Ebene der Frontplatte 1 angeordnet, dabei ist

$R$ - der Abstand zwischen den optischen Achsen der benachbarten Fresnel-Linsen,

*W* - die Breite der Wärme abführenden Unterlage 5,

*H* - der Abstand zwischen der Front 1 und Hinterplatte 4 zur Verminderung des Gesamtumfangs des Moduls und zur Erhöhung und Verbesserung der Fertigungsgerechtheit und des Zusammenbaus des Modulgehäuses.

Die Konstruktion der Kontrollbaugruppe 8 stellt eine gasdichte Isolation jeder Solarzelle 6 vom inneren Umfang des Moduls in der Vorstufe des verfahrenstechnischen Fertigungsablaufs der photoelektrischen Sammelmodule sicher. Das ermöglicht es, die potentiell unzuverlässigen Solarzellen im Voraus auszusortieren und eine erhöhte Widerstandsfähigkeit der photoelektrischen Module gegen Einwirkung der Gesamtheit der ungünstigen Umweltfaktoren sowohl bei der Fertigung der Module als auch während ihres Betriebs sicherzustellen.

Der Einfachheit der Auswertung sowie der vielseitigen Anwendbarkeit der Konstruktion nach ist die Ausführungsform gemäß Fig. 1 die Vorteilhafteste.

Während des Betriebs des photoelektrischen Moduls konzentrieren die normal zu den Sonnenstrahlen ausgerichteten Linsenkonzentratoren 2 (zum Beispiel Fresnel-Linsen 16) das Sonnenlicht und lenken es auf die zusätzlichen optischen Elemente 7, 18, 24, 27 oder 30. Die optischen Elemente 7, 18, 24, 27 oder 30 sind Bestandteile von Kontrollbaugruppen 8 der Solarzellen. Die Solarzellen sind so ausgeführt, dass die individuelle abdichtbare Isolation jeder Solarzelle 6 vom Innenumfang des Moduls sichergestellt ist. Danach fokussieren die Linsenkonzentratoren 2 das Licht auf den Licht aufnehmenden Flächen der Solarzellen 6. Der Einsatz von zusätzlichen optischen Elementen 7 ermöglicht es, das Verhältnis der Sonnenlichtkonzentration mehrfach zu steigern und gleichzeitig den Bereich der zulässigen Entorientierung des Moduls in die Sonnenrichtung zu erhöhen. Außerdem ermöglicht es die Anwendung der Kontrollbaugruppen 8 der individuell abdichtbar und vom Innenumfang des Moduls isolierbar ausgeführten Solarzellen 6, automatisierte Fertigungsabläufe bei ihrer Herstellung anzuwenden und die Aussortierung der Kontrollbaugruppen 8 der Solarzellen noch vor dem Zusammenbau der photoelektrischen Module durchzuführen.

Die Solarzellen 6 wandeln die Lichtquantenenergie in elektrische Energie um, indem sie eine Potentialdifferenz an ihren Kontakten ausbilden. Die durch das Modul erzeugte elektrische Energie wird an einen externen Verbraucher oder zu einem Energiespeicher weitergeleitet. Die von den Solarzellen 6 abgeführte Wärme wird über die Wärme abführenden Metallunterlagen 5 verteilt, auf die Hinterplatte 4 übertragen und dann durch Eigenstrahlung und freie Konvektion an die Umgebung abgegeben.

Die Anwendung des vorgeschlagenen photoelektrischen Moduls ergibt einen beachtlichen Nutzeffekt. Dies ist dadurch bedingt, dass das angemeldete photoelektrische Modul seiner Konstruktion nach einfach aufgebaut ist, hohe photoelektrische und Festigkeitseigenschaften aufweist, die einen zuverlässigen, sicheren und langzeitigen Betrieb sicherstellen. Das Modul ist high-tech-gerecht bei seiner Fertigung und hat eine hohe Energieleistung sowie hohe betriebswirtschaftliche Kennzahlen.

## Patentansprüche

1. Photoelektrisches Modul mit einer Frontplatte (1) aus Silikatglas mit Linsenkonzentratoren (2) aus Silikon auf der Rückseite der Frontplatte (1), Seitenwänden (3) sowie einer Hinterplatte (4), wobei auf Wärme abführenden Unterlagen (5) auf der oberen Seite der Hinterplatte (4) Solarzellen (6) und damit koaxial angeordnete zusätzliche optische Elemente (7) aufgebaut sind,
**dadurch gekennzeichnet,**
**dass** die zusätzlichen optischen Elemente (7) Bestandteil von Kontrollbaugruppen (8) der Solarzellen (6) sind und
**dass** dabei die genannten Kontrollbaugruppen (8) so ausgeführt sind, dass sie eine individuelle Abdichtung jeder Solarzelle (6) und ihre Abtrennung vom inneren Modulumfang sicherstellen.

2. Photoelektrisches Modul nach Anspruch 1,
**dadurch gekennzeichnet,**
**dass** Linsenkonzentratoren (2) als Fresnel-Linsen (16) ausgeführt sind.

3. Photoelektrisches Modul nach Anspruch 1,
**dadurch gekennzeichnet,**
**dass** Linsenkonzentratoren (2) in Form von plankonvexen Linsen (17) ausgebildet sind.

4. Photoelektrisches Modul nach Anspruch 1,
**dadurch gekennzeichnet,**
**dass** zusätzliche optische Elemente (7) in Form von plankonvexen Linsen (18) ausgebildet sind.

5. Photoelektrisches Modul nach Anspruch 1,
**dadurch gekennzeichnet,**
**dass** zusätzliche optische Elemente (7) als Metallfokone (22) mit einer Schutzabdeckung (24) aus Glas ausgebildet sind.

6. Photoelektrisches Modul nach Anspruch 1,
**dadurch gekennzeichnet,**
**dass** zusätzliche optische Elemente (7) als Fokone (26) mit innerer Totalreflexion ausgeführt sind.

7. Photoelektrisches Modul nach Anspruch 6,
**dadurch gekennzeichnet,**
**dass** zusätzliche optische Elemente (7) als Fokone (26) mit innerer Totalreflexion ausgeführt und aus Kunststoff gefertigt sind.

8. Photoelektrisches Modul nach Anspruch 7,
**dadurch gekennzeichnet,**

**dass** Fokone (26) mit innerer Totalreflexion aus Kunststoff von oben mit einer Schutzabdeckung (27) aus Glas optisch verbunden sind.

9. Photoelektrisches Modul nach Anspruch 8,
**dadurch gekennzeichnet,**
**dass** die Außenfläche der Schutzabdeckung (27) aus Glas mit einem Reflexionsschutzüberzug beschichtet ist.

10. Photoelektrisches Modul nach Anspruch 1,
**dadurch gekennzeichnet,**
**dass** die Verbindungsstellen zwischen der Frontplatte (1), den Seitenwänden (3) und der Hinterplatte (4) luftdicht sind.

11. Photoelektrisches Modul nach Anspruch 10,
**dadurch gekennzeichnet,**
**dass** die Seitenwände (3) und/oder die Hinterplatte (4) eine oder mehrere flexible Einsatzstücke (25) aufweisen.

12. Photoelektrisches Modul nach Anspruch 11,
**dadurch gekennzeichnet,**
**dass** die flexiblen Einsatzstücke (25) als ein Balg ausgebildet sind.

13. Photoelektrisches Modul nach Anspruch 11,
**dadurch gekennzeichnet,**
**dass** die flexiblen Einsatzstücke (25) aus einem kautschukähnlichen Material gefertigt sind.

14. Photoelektrisches Modul nach Anspruch 10,
**dadurch gekennzeichnet,**
**dass** sein Innenumfang luftdicht mit einer Einrichtung (31) verbunden ist, welche den Druckausgleich innerhalb und außerhalb des Moduls sicherstellt.

15. Photoelektrisches Modul nach Anspruch 1,
**dadurch gekennzeichnet,**
**dass** die Vorderfläche der Frontplatte (1) mit einem Reflexionsschutzüberzug beschichtet ist.

16. Photoelektrisches Modul nach Anspruch 4,
**dadurch gekennzeichnet,**
**dass** die beiden Oberflächen der sekundären optischen Elemente, welche als plankonvexe Linsen (18) ausgebildet sind, mit Reflexionsschutzüberzügen beschichtet sind.

17. Photoelektrisches Modul nach Anspruch 1,
**dadurch gekennzeichnet,**
**dass** die Hinterplatte (4) aus Metall gefertigt ist, welches mit einer Wärme leitenden Elektroisolierschicht versehen ist.

18. Photoelektrisches Modul nach Anspruch 17,
**dadurch gekennzeichnet,**
**dass** die Hinterplatte (4) aus verzinktem Stahl mit einer Kunststoffbeschichtung gefertigt ist.

19. Photoelektrisches Modul nach Anspruch 17,
**dadurch gekennzeichnet,**
**dass** die Hinterplatte (4) aus Emailstahl gefertigt ist.

20. Photoelektrisches Modul nach Anspruch 1,
**dadurch gekennzeichnet,**
**dass** die Hinterplatte (4) aus Glas gefertigt ist.

21. Photoelektrisches Modul nach Anspruch 1,
**dadurch gekennzeichnet,**
**dass** die Seitenwände (3) aus Aluminium oder Aluminiumlegierung gefertigt sind.

22. Photoelektrisches Modul nach Anspruch 1,
**dadurch gekennzeichnet,**
**dass** die Seitenwände (3) aus verzinktem Stahl gefertigt sind.

23. Photoelektrisches Modul nach Anspruch 22,
**dadurch gekennzeichnet,**
**dass** die Seitenwände (3) aus verzinktem Stahl mit einer Kunststoffbeschichtung gefertigt sind.

24. Photoelektrisches Modul nach Anspruch 1,
**dadurch gekennzeichnet,**
**dass** die Seitenwände (3) aus Kunststoff gefertigt sind.

25. Photoelektrisches Modul nach Anspruch 4,
**dadurch gekennzeichnet,**
**dass** die als plankonvexe Linsen (18) ausgebildeten sekundären optischen Elemente aus Silikatglas gefertigt sind.

26. Photoelektrisches Modul nach Anspruch 1,
**dadurch gekennzeichnet,**
**dass** die Seitenwände (3) unter einem Winkel von

$$0 \le a < arctg \frac{R - W}{2H}$$ zur Normalen zur Ebene der Frontplatte (1) angeordnet sind, wobei $R$ der Abstand zwischen den optischen Achsen der benachbarten Fresnel-Linsen (16), $W$ die Breite der Wärme abführenden Unterlage (5) und $H$ der Abstand zwischen der Front- (1) und Hinterplatte (4) bedeuten.

Fig. 1

Fig. 2

Fig. 3

Fig. 4

Fig. 5

## INTERNATIONAL SEARCH REPORT

| | International application No. |
|---|---|
| | PCT/RU 2007/000197 |

A. CLASSIFICATION OF SUBJECT MATTER

H01L 31/042 (2006.01)

According to International Patent Classification (IPC) or to both national classification and IPC

B. FIELDS SEARCHED

Minimum documentation searched (classification system followed by classification symbols)

F24J 2/00-2/34, 2/42, F03G 6/00-6/06, C02F 1/00, 1/14, E04D 13/00, 13/18, H01L 31/00, 31/04-31/058, H02N 6/00

Documentation searched other than minimum documentation to the extent that such documents are included in the fields searched

Electronic data base consulted during the international search (name of data base and, where practicable, search terms used)

RUPAT, RUABRU, RUPAT OLD, RUABUI, Esp@cenet, PAJ, USPTO DB

C. DOCUMENTS CONSIDERED TO BE RELEVANT

| Category* | Citation of document, with indication, where appropriate, of the relevant passages | Relevant to claim No. |
|---|---|---|
| X | RU 44002 U1 (ALFEROV ZHOREC IVANOVICH et al.) 10.02.2005, pages 9-10, 17, figure 5 | |
| A | RU 2002135304 A (OBSCHESTVO S OGRANICHENNOI OTVETSTVENNOSTIJU "DELOS COLAR") 20.06.2004 | |
| A | JP 58-048477 A (NEC CORP) 22.03.1983 | |
| A | US 2004/0194820 A1 (STEVEN BARONE) 07.10.2004 | |

☐ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 December 2007 | 10 January 2008 |

| Name and mailing address of the ISA/ | Authorized officer |
|---|---|
| RU | |
| Facsimile No. | Telephone No. |

Form PCT/ISA/210 (second sheet) (July 1998)

**IN DER BESCHREIBUNG AUFGEFÜHRTE DOKUMENTE**

**In der Beschreibung aufgeführte Patentdokumente**

- RU 44002

**In der Beschreibung aufgeführte Nicht-Patentliteratur**

- *CONFERENCE RECORD OF THE TWENTY-EIGHT IEEE PHOTOVOLTAIC SPECIALISTS CONFERENCE-2000,* 2000, 1169-1172